# EUROPEAN PATENT APPLICATION

(11) **EP 4 769 803 A1**
(43) Date of publication of application: **01.07.2026**
(21) Application number: 23955329.0
(22) Date of filing: 07.12.2023
(51) Int. Cl.: H01M 50/519, H01M 50/502

(54) **SAMPLING APPARATUS, BATTERY, AND ELECTRIC DEVICE**

(30) Priority: 09.10.2023 CN 202322696895 U
(71) Applicant: Contemporary Amperex Technology Co., Limited, Ningde, Fujian 352100 (CN)
(72) Inventor: TAN, Yu, Ningde, Fujian 352100 (CN); LV, Juanxia, Ningde, Fujian 352100 (CN)
(74) Representative: Gong, Jinping
(86) International application number: PCT/CN2023/137094
(87) International publication number: WO 2025/076976

(57) **Abstract**

The present application provides a sampling apparatus (30), a battery (100) and an electrical device. The sampling apparatus (30) comprises a circuit component (31), a first connection element (32) and a second connection element (33). The first connection element (32) and the second connection element (33) are electrically connected to the circuit component (31). At least a part of the second connection element (33) and at least a part of the first connection element (32) are stacked along a thickness direction of the circuit component (31).

## Description

### CROSS-REFERENCE

The present application is based on Chinese patent application No. 202322696895.4 filed on October 09, 2023 and titled "SAMPLING APPARATUS, BATTERY, AND ELECTRICAL DEVICE", which is incorporated into the present application by reference in its entirety.

### TECHNICAL FIELD

The present application belongs to the technical field of batteries, and more specifically, relates to a sampling apparatus, a battery, and an electrical device.

### BACKGROUND

At present, with the rapid development of electronic devices and electric vehicles, the application of batteries has become more and more extensive, and higher requirements are put on the volume energy density of batteries.

A battery includes a battery cell and a sampling apparatus. The sampling apparatus is electrically connected to the battery cell to collect the operating status signal of the battery cell. However, due to the unreasonable design of the spatial layout structure of the sampling apparatus, the space utilization rate of the battery is reduced, thereby causing the volume energy density of the battery to decrease. Therefore, how to optimize the spatial layout structure of the sampling apparatus has become a technical problem that needs to be solved urgently.

### SUMMARY

It is an objective of embodiments of the present application to provide a sampling apparatus, a battery, and an electrical device to solve the technical problem in the related art that the volume energy density of the battery decreases due to the unreasonable design of the spatial layout structure of the sampling apparatus.

To achieve the above objective, the embodiments of the present application adopt a technical solution of providing a sampling apparatus, including:
a circuit component;
a first connection element electrically connected to the circuit component; and
a second connection element electrically connected to the circuit component, at least a part of the second connection element and at least a part of the first connection element being stacked along a thickness direction of the circuit component.

The sampling apparatus provided in the embodiments of the present application has at least the following beneficial effects: at least a part of the second connection element and at least a part of the first connection element are stacked along a thickness direction of the circuit component in the sampling apparatus provided in the embodiments of the present application, which effectively reduces the width dimension of the sampling apparatus compared with the layout structure of a traditional sampling apparatus in which a plurality of connection elements are arranged in sequence along the width direction of the circuit component, making the structure of the sampling apparatus more compact, thereby effectively improving the space utilization rate of the battery using the aforementioned sampling apparatus and effectively improving the volume energy density of the battery.

In some embodiments of the present application, the circuit component has a first connecting surface and a second connecting surface, the first connecting surface and the second connecting surface are arranged back to back along the thickness direction of the circuit component, the first connection element is arranged on the first connecting surface, and the second connection element is arranged on the second connecting surface.

By adopting the above technical solution, the first connection element and the second connection element can be conveniently connected to the circuit component, so that at least a part of the second connection element and at least a part of the first connection element are stacked along the thickness direction of the circuit component.

In some embodiments of the present application, the circuit component includes a first connecting portion, a second connecting portion and a main body portion that are connected in sequence, the first connecting portion has a first connecting surface, the second connecting portion has a second connecting surface, and the first connecting portion is folded relative to the second connecting portion so that the first connecting surface and the second connecting surface are arranged back to back along the thickness direction of the circuit component.

By adopting the above technical solution, at least a part of the second connection element and at least a part of the first connection element can be conveniently stacked along the thickness direction of the circuit component.

In some embodiments of the present application, the circuit component is a flexible printed circuit.

By adopting the above technical solution, not only can the first connecting portion be conveniently folded relative to the second connecting portion, but also can the circuit component better adapt to the assembly environment, thereby effectively improving the assembly flexibility of the sampling apparatus.

In some embodiments of the present application, the sampling apparatus further includes a first reinforcement component, which is attached between the first connecting portion and the second connecting portion and is located between the first connecting surface and the second connecting surface.

By adopting the above technical solution, in the process of connecting the first connection element and the second connection element to the circuit component, the first reinforcement component can serve to support the first connecting portion and the second connecting portion, which facilitates the connection of the first connection element and the second connection element to the first connecting portion and the second connecting portion respectively, thereby effectively reducing the risk of poor connection between the first connection element and the circuit component and between the second connection element and the circuit component.

In some embodiments of the present application, the first connecting portion and the second connecting portion are connected to the first reinforcement component.

By adopting the above technical solution, the positions of the first connecting portion, the second connecting portion and the first reinforcement component relative to one another are effectively restricted, thereby effectively reducing the risk of the first reinforcement component being separated from the first connecting portion and/or the second connecting portion.

In some embodiments of the present application, the circuit component has a first electrical wiring electrically connected to the first connection element and a second electrical wiring electrically connected to the second connection element, the first electrical wiring includes a first main body section and a first corner section arranged at an angle to the first main body section, the first main body section is arranged on the side of the second electrical wiring facing away from the second connection element and extends from the main body portion to the first connecting portion, and the first corner section is connected between the first connection element and the end of the first main body section close to the first connection element.

By adopting the above technical solution, the first electrical wiring can conveniently avoid the second connection element and the second electrical wiring for electrically connecting the second connection element, effectively optimizing the circuit structure of the circuit component and making the structure of the circuit component more compact, thereby effectively reducing the space occupied by the sampling apparatus and further improving the volume energy density of the battery using the aforementioned sampling apparatus.

In some embodiments of the present application, the second electrical wiring includes a second main body section and a second corner section arranged at an angle to the second main body section, the second main body section extends from the main body portion to the second connecting portion, and the second corner section is connected between the second connection element and the end of the second main body section close to the second connection element.

By adopting the above technical solution, the circuit structure of the circuit component is further optimized, making the structure of the circuit component more compact, thereby further reducing the space occupied by the sampling apparatus and further improving the volume energy density of the battery using the aforementioned sampling apparatus.

In some embodiments of the present application, the circuit component includes a first board body and a second board body which are stacked, the first board body has a first connecting surface, and the second board body has a second connecting surface.

By adopting the above technical solution, at least a part of the second connection element and at least a part of the first connection element can be conveniently stacked along the thickness direction of the circuit component.

In some embodiments of the present application, the first board body and the second board body are flexible printed circuits.

By adopting the above technical solution, the circuit component can better adapt to the assembly environment, thereby effectively improving the assembly flexibility of the sampling apparatus.

In some embodiments of the present application, the sampling apparatus further includes a second reinforcement component, which is attached between the first board body and the second board body and is located between the first connecting surface and the second connecting surface.

By adopting the above technical solution, in the process of connecting the first connection element and the second connection element to the circuit component, the second reinforcement component can serve to support the first board body and the second board body, which facilitates the connection of the first connection element and the second connection element to the first board body and the second board body respectively, thereby effectively reducing the risk of poor connection between the first connection element and the first board body and between the second connection element and the second board body.

In some embodiments of the present application, the first board body and the second board body are connected to the second reinforcement component.

By adopting the above technical solution, the positions of the first board body, the second board body and the second reinforcement component relative to one another are effectively restricted, thereby effectively reducing the risk of the second reinforcement component being separated from the first board body and/or the second board body.

In some embodiments of the present application, the first board body has a third electrical wiring electrically connected to the first connection element, and the third electrical wiring extends along the length direction of the circuit component; the second board body has a fourth electrical wiring electrically connected to the second connection element, and the fourth electrical wiring extends along the length direction of the circuit component.

By adopting the above technical solution, the circuit structure of the circuit component is effectively optimized, making the structure of the circuit component more compact, thereby effectively reducing the space occupied by the sampling apparatus and further improving the volume energy density of the battery using the aforementioned sampling apparatus.

In some embodiments of the present application, the circuit component includes a third board body, the third board body is a rigid printed circuit, and the third board body has a first connecting surface and a second connecting surface.

By adopting the above technical solution, the third board body has good rigidity, which facilitates the connection of the first connection element and the second connection element to the third board body, thereby effectively reducing the risk of poor connection between the first connection element and the third board body and between the second connection element and the third board body, and there is no need to provide additional reinforcement components, which effectively simplifies the structure of the sampling apparatus, thereby effectively reducing the space occupied by the sampling apparatus, and further improving the volume energy density of the battery using the aforementioned sampling apparatus.

In some embodiments of the present application, the circuit component further includes a fourth board body, the fourth board body is a flexible printed circuit, and the fourth board body is electrically connected to the third board body.

By adopting the above technical solution, the circuit component can better adapt to the assembly environment, thereby effectively improving the assembly flexibility of the sampling apparatus.

In some embodiments of the present application, the third board body has a fifth electrical wiring arranged on the first connecting surface and a sixth electrical wiring arranged on the second connecting surface, and the circuit component further includes a fourth board body, the fourth board body has a seventh electrical wiring and an eighth electrical wiring, the seventh electrical wiring is electrically connected to the first connection element through the fifth electrical wiring, and the eighth electrical wiring is electrically connected to the second connection element through the sixth electrical wiring.

By adopting the above technical solution, the first connection element and the second connection element can be conveniently electrically connected to the circuit component.

In some embodiments of the present application, a wire hole running through the first connecting surface and the second connecting surface is formed in the third board body; the fourth board body is connected to the first connecting surface, and the eighth electrical wiring is electrically connected to the sixth electrical wiring through the wire hole; or, the fourth board body is connected to the second connecting surface, and the seventh electrical wiring is electrically connected to the fifth electrical wiring through the wire hole.

By adopting the above technical solution, the circuit structure of the circuit component is effectively optimized, making the structure of the circuit component more compact, thereby effectively reducing the space occupied by the sampling apparatus and further improving the volume energy density of the battery using the aforementioned sampling apparatus.

In some embodiments of the present application, the first connection element has a first plug port, the second connection element has a second plug port, and the orientation of the first plug port is the same as the orientation of the second plug port.

By adopting the above technical solution, the first connection element and the second connection element can be plugged and unplugged along the same direction, thereby effectively improving the efficiency of connecting the sampling apparatus with the external apparatus.

In some embodiments of the present application, the orientation of the first plug port is parallel to the width direction of the circuit component; or, the orientation of the first plug port is parallel to the length direction of the circuit component.

By adopting the above technical solution, the risk of interference between the first connection element and the second connection element and other components of the battery during the plugging and unplugging process is effectively reduced.

An embodiment of the present application further provides a battery, including the sampling apparatus of any one of the aforementioned embodiments.

The battery provided in the embodiment of the present application has at least the following beneficial effects: as the battery provided by the embodiment of the present application uses the sampling apparatus of any of the aforementioned embodiments, the space utilization rate of the battery is effectively improved, thereby effectively improving the volume energy density of the battery.

In some embodiments of the present application, the battery further includes a plurality of battery cells, and the plurality of battery cells are electrically connected to the circuit component.

By adopting the above technical solution, the operating status signal of the battery cell can be conveniently collected.

In some embodiments of the present application, a plurality of battery cells are stacked in sequence to form a battery core group, and the circuit component extends along the stacking direction of the plurality of battery cells.

By adopting the above technical solution, the sampling apparatus can make full use of the length space of the battery, thereby further improving the space utilization rate of the battery and further improving the volume energy density of the battery.

In some embodiments of the present application, there are a plurality of battery core groups, which are arranged in sequence along a direction perpendicular to the stacking direction of the plurality of battery cells, and the thickness direction of the circuit component is perpendicular to the arrangement direction of the plurality of battery core groups.

By adopting the above technical solution, not only can the sampling apparatus make full use of the length space of the battery, but also the width space of the battery occupied by the sampling apparatus is effectively reduced, thereby further improving the space utilization rate of the battery and further improving the volume energy density of the battery.

In some embodiments of the present application, the battery further includes a mounting seat, and the first connection element and the second connection element are mounted on the mounting seat.

By adopting the above technical solution, the first connection element and the second connection element can be conveniently fixed.

In some embodiments of the present application, a receiving groove is formed in the mounting seat, and the first connection element and/or the second connection element is received in the receiving groove.

By adopting the above technical solution, the assembly structure between the first connection element and/or the second connection element and the mounting seat becomes more compact, thereby further improving the space utilization rate of the battery and further improving the volume energy density of the battery.

An embodiment of the present application further provides an electrical device, including the battery according to any of the aforementioned embodiments.

The electrical device provided in the embodiment of the present application has at least the following beneficial effects: as the electrical device provided in the embodiment of the present application uses the battery of any one of the aforementioned embodiments, the battery life performance of the electrical device is effectively improved.

### BRIEF DESCRIPTION OF DRAWINGS

In order to more clearly describe technical solutions of embodiments of the present application, drawings to be used in the description of the embodiments or the prior art will be briefly introduced below. Apparently, the drawings described below show merely some embodiments of the present application. For persons of ordinary skills in the art, other drawings can also be obtained based on these drawings without creative efforts.

In order to more clearly describe technical solutions of embodiments of the present application, drawings to be used in the description of the embodiments or the prior art will be briefly introduced below. Apparently, the drawings described below show merely some embodiments of the present application. For persons of ordinary skills in the art, other drawings can also be obtained based on these drawings without creative efforts.
FIG. 1 is a schematic structural diagram of a vehicle provided by an embodiment of the present application;
FIG. 2 is a schematic exploded structural diagram of a battery provided by an embodiment of the present application;
FIG. 3 is a schematic structural diagram of a sampling apparatus in the battery shown in FIG. 2;
FIG. 4 is a schematic side structural diagram of the sampling apparatus shown in FIG. 3;
FIG. 5 is a schematic circuit structural diagram of the sampling apparatus shown in FIG. 3;
FIG. 6 is a schematic exploded structural diagram of a battery provided by another embodiment of the present application;
FIG. 7 is a schematic structural diagram of a sampling apparatus in the battery shown in FIG. 6;
FIG. 8 is a schematic side structural diagram of the sampling apparatus shown in FIG. 7;
FIG. 9 is a first schematic circuit structural diagram of the sampling apparatus shown in FIG. 7;
FIG. 10 is a second schematic circuit structural diagram of the sampling apparatus shown in FIG. 7;
FIG. 11 is a schematic exploded structural diagram of a battery provided by yet another embodiment of the present application;
FIG. 12 is a schematic structural diagram of a sampling apparatus in the battery shown in FIG. 11;
FIG. 13 is a schematic side structural diagram of the sampling apparatus shown in FIG. 12;
FIG. 14 is a first schematic circuit structural diagram of the sampling apparatus shown in FIG. 12; and
FIG. 15 is a second schematic circuit structural diagram of the sampling apparatus shown in FIG. 12.

### List of Reference Numerals in the Drawings:

1000. vehicle;
100. battery;
10. box; 11. first portion; 12. second portion;
20. battery core group; 21. battery cell;
30. sampling apparatus; 31. circuit component; 311. first connecting surface; 312. second connecting surface; 313. first connecting portion; 314. second connecting portion; 315. main body portion; 3151. first electrical wiring; 31511. first main body section; 31512. first corner section; 3152. second electrical wiring; 31521. second main body section; 31522. second corner section; 316. first board body; 3161. third electrical wiring; 317. second board body; 3171. fourth electrical wiring; 318. third board body; 3181. fifth electrical wiring; 3182. sixth electrical wiring; 3183. wire hole; 3184. third connecting hole; 319. fourth board body; 3191. seventh electrical wiring; 3192. eighth electrical wiring; 32. first connection element; 321. first plug port; 33. second connection element; 331. second plug port; 34. first reinforcement component; 341. first connecting hole; 35. second reinforcement component; 351. second connecting hole; 36. sampling device;
40. battery management module;
50. mounting seat; 51. receiving groove;
200: controller;
300: motor.

### DETAILED DESCRIPTION

In order to make the technical problems, technical solutions, and beneficial effects to be solved by the present application clearer, the following is a further detailed explanation of the present application in conjunction with the accompanying drawings and embodiments. It should be understood that the specific embodiments described herein are merely used to explain the present application but are not intended to limit the present application.

It should be noted that when an element is referred to as being "fixed to" or "arranged to" another element, the element can be directly or indirectly on another element. When an element is referred to as being "connected" to another element, the component can be directly or indirectly connected to the another element.

It should be understood that orientations or positional relationships indicated by the terms "length", "width", "upper", "lower", "front", "rear", "left", "right", "vertical", "horizontal", "top", "bottom", "inner", "outer", and the like are orientations or positional relationships as shown in the drawings, and are only for the purpose of facilitating and simplifying the descriptions of the present application instead of indicating or implying that devices or elements indicated must have particular orientations, and be constructed and operated in the particular orientations, so that these terms are not construed as limiting the present application.

In addition, the terms "first" and "second" are used for descriptive purposes only, and cannot be construed as indicating or implying relative importance or implicitly indicating the number of technical features indicated. From this, features defined as "first" and second" may explicitly or implicitly include one or more features. In the description of the present application, "a plurality of" means two or more, unless otherwise expressly and specifically defined.

At present, from the perspective of the development of the market situation, application of batteries is increasingly more extensive. Batteries are not only applied in energy storage power source systems such as hydraulic, thermal, wind, and solar power stations, but also widely applied in fields of, for example, electric vehicles such as electric bicycles, electric motorcycles, and electric cars, military equipment and aerospace, and the like. With the continuous expansion of the application field of batteries, the market demand thereof is also constantly expanding, and higher requirements are put on the volume energy density of batteries.

A battery generally includes a battery cell, a sampling apparatus and a battery management module. A battery cell is the smallest storage unit for storing electrical energy. The sampling apparatus is used to electrically connect the battery cell to the battery management module to collect the operating status signal of the battery cell and transmit the operating status signal of the battery cell to the battery management module so that the battery management module can monitor the operating status of the battery cell. Specifically, the sampling apparatus generally includes a circuit component and a connection element. The circuit component is electrically connected to the battery cell. The connection element is electrically connected to the circuit component and is electrically connected to the battery management module by means of plugging. The operating status signal of the battery cell is transmitted to the battery management module via the circuit component and the connection element in sequence.

In the related art, there are usually a plurality of battery cells, and the plurality of battery cells are stacked in sequence to form a battery core group. The plurality of battery core groups are arranged in sequence along a direction perpendicular to the stacking direction of the battery cells. The circuit component extends along the stacking direction of the plurality of battery cells in the battery core group so as to be electrically connected to the plurality of battery cells in the battery core group. The width direction of the circuit component is parallel to the arrangement direction of the plurality of battery core groups. The connection element is usually arranged between the end of the battery core group and the battery management module so as to electrically connect the circuit component to the battery management module.

As people's requirements for the battery life performance of electrical devices continue to increase, the number of battery cells in the battery core group is also increasing. The number of pins of the connection element corresponds to the number of battery cells in the battery core group, that is, the number of pins of the connection element needs to increase with the increase in the number of battery cells. However, if the number of pins of the connection element is too large, not only is the difficulty of manufacturing the connection element increased, but also the difficulty of plugging and unplugging the connection element is increased. Therefore, the sampling apparatus can be electrically connected to more battery cells only if the number of connection elements of the sampling apparatus is increased. At present, the plurality of connection elements are laid out by being arranged in sequence along the width direction of the circuit component. However, as the number of connection elements increases, the width dimension of the sampling apparatus also increases, so that the sampling apparatus needs to occupy more width space of the battery, which is adverse to improving the space utilization rate of the battery, thereby causing the volume energy density of the battery to decrease.

In order to reduce the width dimension of the sampling apparatus, at least a part of the second connection element and at least a part of the first connection element are stacked along a thickness direction of the circuit component in the sampling apparatus provided in the embodiments of the present application, which effectively reduces the width dimension of the sampling apparatus compared with the layout structure of a traditional sampling apparatus in which a plurality of connection elements are arranged in sequence along the width direction of the circuit component, making the structure of the sampling apparatus more compact, thereby effectively improving the space utilization rate of the battery using the aforementioned sampling apparatus and effectively improving the volume energy density of the battery.

The sampling apparatus disclosed in the embodiments of the present application can be applied to an electric device and used to collect operating status signals of electrical components in the electric device. The electric device may be, but is not limited to, batteries, motors, compressors, computers, displays, etc.

For ease of description, the following embodiments are illustrated by taking an electric device in an embodiment of the present application being a battery as an example.

As for a battery and an electrical device using the battery as a power source disclosed in the embodiments of the present application, the electrical device may be, but is not limited to, a vehicle, a mobile phone, a portable device, a laptop computer, a ship, a spacecraft, an electric toy, an electric tool, and the like. The vehicle may be a fuel vehicle, a gas vehicle, or a new energy vehicle, and the new energy vehicle may be an all-electric vehicle, a hybrid electric vehicle, or an extended range electric vehicle. The spacecraft may be an aircraft, a rocket, a space shuttle or a spacecraft. The electric toy may be a fixed electric toy or a mobile electric toy, such as a game machine, an electric vehicle toy, an electric ship toy, an electric airplane toy, and the like. The electric tool may be an electric metal cutting tool, an electric grinding tool, an electric assembling tool, or an electric tool for railways, such as an electric drill, an electric grinding machine, an electric wrench, an electric screwdriver, an electric hammer, an electric impact drill, a concrete vibrator, an electric planer, and the like.

For ease of description, the following embodiments are illustrated by taking an electrical device in an embodiment of the present application being a vehicle as an example.

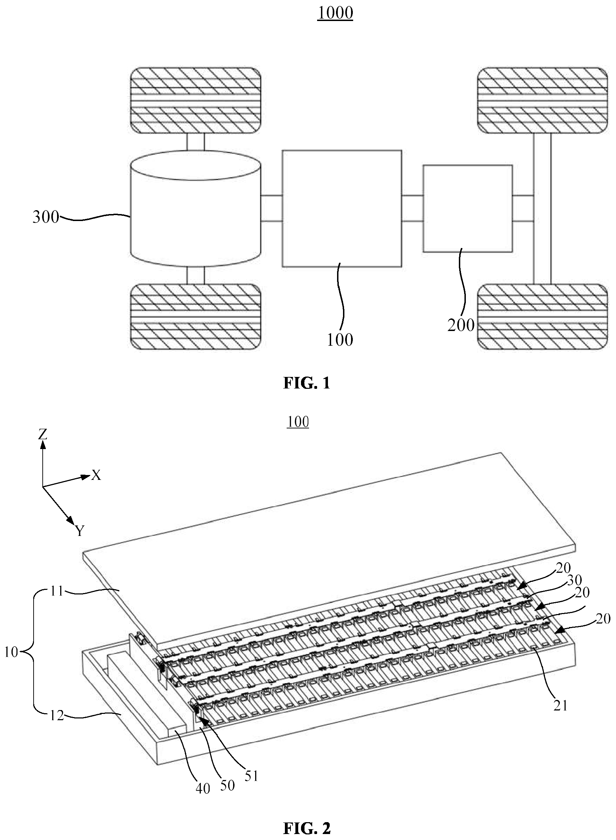

Referring to FIG. 1, FIG. 1 is a schematic structural diagram of a vehicle 1000 provided by an embodiment of the present application. A battery 100 is provided inside the vehicle 1000. The battery 100 may be provided at the bottom, or head, or tail of the vehicle 1000. The battery 100 may be used as a power supply for the vehicle 1000, for example, the battery 100 may be used as an operating power source for the vehicle 1000. The vehicle 1000 may further include a controller 200 and a motor 300. The controller 200 is configured to control the battery 100 to supply power to the motor 300, for example, to meet a demand for working power during starting, navigation, and driving of the vehicle 1000.

In some embodiments of the present application, the battery 100 not only may serve as the operating power source of the vehicle 1000, but also may serve as a driving power source of the vehicle 1000, replacing or partially replacing fuel or natural gas to provide driving power for the vehicle 1000.

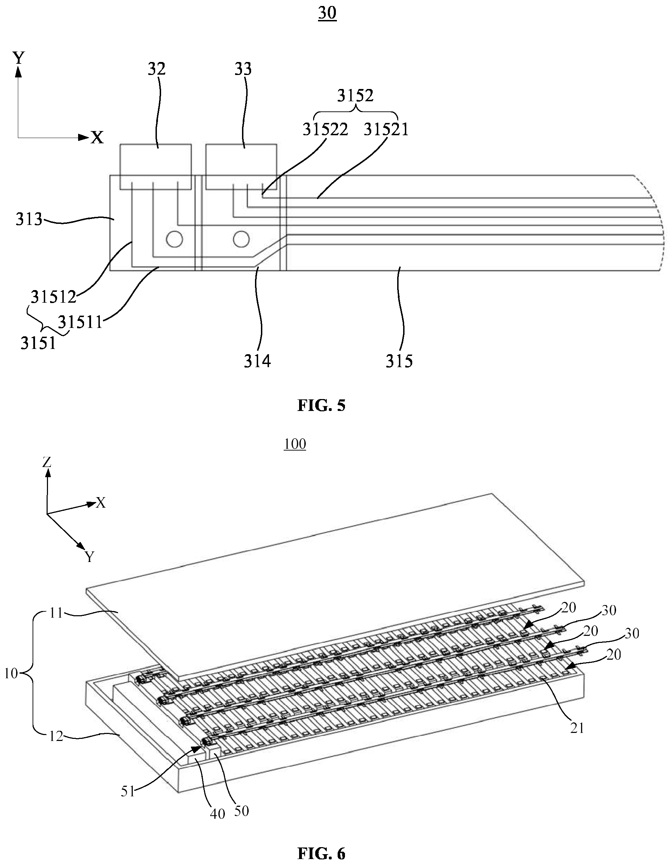

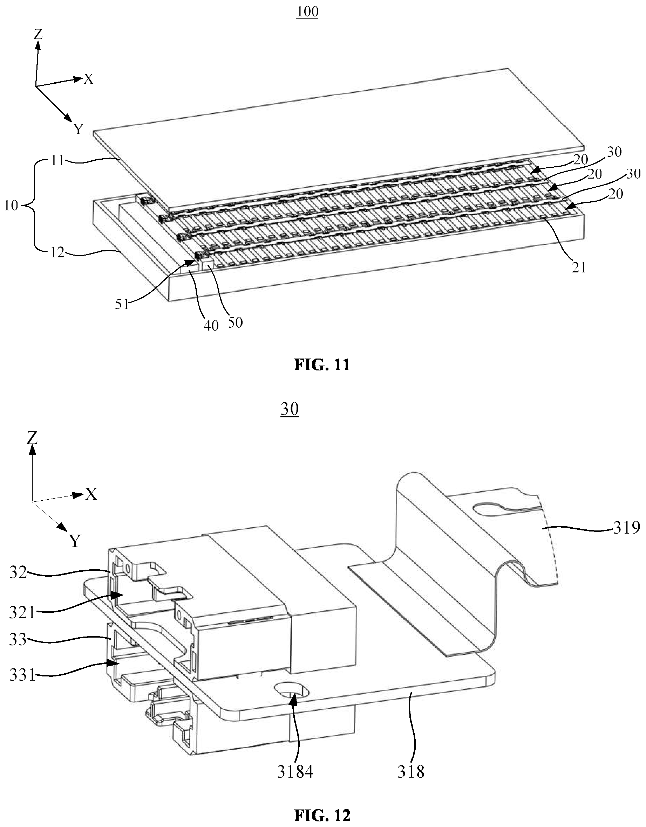

Referring also to FIGS. 2, 6 and 11, FIG. 2 is a schematic exploded structural diagram of a battery 100 provided by an embodiment of the present application; FIG. 6 is a schematic exploded structural diagram of a battery 100 provided by another embodiment of the present application; and FIG. 11 is a schematic exploded structural diagram of a battery 100 provided by yet another embodiment of the present application. The battery 100 includes a box 10, a battery cell 21, and a sampling apparatus 30. The box 10 is used to provide an accommodating space for the battery cell 21 and the sampling apparatus 30, and the box 10 may be of a variety of structures. In some embodiments, the box 10 may include a first portion 11 and a second portion 12, the first portion 11 and the second portion 12 cover each other, and the first portion 11 and the second portion 12 together define the accommodating space for accommodating the battery cell 21 and the sampling apparatus 30. The second portion 12 may be of a hollow structure with an opening at one end, and the first portion 11 may be of a plate-shaped structure, where the first portion 11 covers the opening side of the second portion 12 such that the first portion 11 and the second portion 12 together define the accommodating space. The first portion 11 and the second portion 12 may each be of a hollow structure with an opening at one end, where the opening side of the first portion 11 covers the opening side of the second portion 12. Of course, the box 10 formed by the first portion 11 and the second portion 12 may be of a variety of shapes, such as a cylinder and a rectangular solid.

In some embodiments, the box 10 may serve as a part of a chassis structure of the vehicle 1000. For example, a part of the box 10 may become at least a part of the floor of the vehicle 1000, or a part of the box 10 may become at least a part of the cross beam and the longitudinal beam of the vehicle 1000.

Of course, in some embodiments, the battery 100 may not include the box 10, but a plurality of battery cells 21 may be electrically connected and formed into a whole through a necessary fixing structure and are then assembled into the vehicle 1000.

In the battery 100, there may be a plurality of battery cells 21, and the plurality of battery cells 21 are stacked in sequence to form a battery core group 20. There may be one or more battery core groups 20. In some embodiments, there are a plurality of battery core groups 20, and the plurality of battery core groups 20 are arranged in sequence along a direction perpendicular to the stacking direction of the battery cells 21. The plurality of battery cells 21 may be connected in series, in parallel or in series-parallel connection. The series-parallel connection means that some of the plurality of battery cells 21 are connected in series and some are connected in parallel. The plurality of battery cells 21 in the battery core group 20 may be directly connected in series, in parallel, or in series-parallel connection, and then the battery core group 20 is accommodated in the box 10. Of course, the battery 100 may alternatively be achieved by first connecting the plurality of battery cells 21 in the battery core group 20 in series or in parallel or in parallel-series connection to form a battery module, and connecting a plurality of battery modules in series or in parallel or in parallel-series connection to form a whole that is accommodated in the box 10. The battery 100 may further include other functional components. For example, the battery 100 may further include a busbar for electrically connecting the plurality of battery cells 21.

Specifically, each battery cell 21 may be a secondary battery or a primary battery, where the secondary battery refers to a battery cell 21 that can continue to be used by activating an active material through charging after the battery cell 21 is discharged, and the primary battery refers to a battery cell 21 that cannot continue to be used by activating the active material through charging after the battery cell 21 is discharged. The battery cell 21 may also be a lithium-ion battery cell, a sodium-ion battery cell, a sodium-lithium-ion battery cell, a lithium-metal battery cell, a sodium-metal battery cell, a lithium-sulfur battery cell, a magnesium-ion battery cell, a nickel-metal hydride battery cell, a nickel-cadmium battery cell, or a lead storage battery cell. The battery cell 21 may be a cylindrical battery cell, a prismatic battery cell, a pouch battery cell, or a battery cell 21 of other shapes. The prismatic battery cell includes a square-shell battery cell, a blade-shaped battery cell, and a polygonal prismatic battery cell (e.g., the polygonal prismatic battery cell is a hexagonal prismatic battery cell). The present application imposes no specific limitations.

The sampling apparatus 30 is electrically connected to the plurality of battery cells 21 to collect operating status signals of the battery cells 21. The operating status signal of the battery cells 21 may be, but is not limited to, a temperature signal, a voltage signal, a current signal, a pressure signal, and the like. The battery 100 may further include a battery management module 40, and the sampling apparatus 30 is electrically connected to the battery management module 40 to transmit the operating status signal of the battery cell 21 to the battery management module 40. The battery management module 40 can adjust the operating status of the battery cell 21 according to the operating status signal of the battery cell 21. For example, the sampling apparatus 30 is used to collect the temperature signal of the battery cell 21. The battery 100 may further include a heat exchange apparatus electrically connected to the battery management module 40. When the operating temperature of the battery cell 21 is too high or too low, the battery management module 40 can control the heat exchange efficiency of the heat exchange apparatus to maintain the operating temperature of the battery cell 21 within an appropriate range.

In order to explain the technical solutions provided by the present application, detailed description is to be made hereinafter in conjunction with specific accompanying drawings and embodiments. For the convenience of description, the stacking direction of the plurality of battery cells 21 is defined as the length direction of the battery 100, such as the direction X as shown in FIGS. 2 to 15, the arrangement direction of the plurality of battery core groups 20 is defined as the width direction of the battery 100, such as the direction Y as shown in FIGS. 2, 3, 5 to 7, 9 to 12, 14 and 15, and the direction perpendicular to the length and width directions of the battery 100 is defined as the height direction of the battery 100, such as the direction Z as shown in FIGS. 2 to 4, 6 to 8 and 11 to 13.

In a first aspect, with reference to FIGS. 2 to 15 together, an embodiment of the present application provides a sampling apparatus 30, including a circuit component 31, a first connection element 32, and a second connection element 33. The first connection element 32 and the second connection element 33 are electrically connected to the circuit component 31, so that at least a part of the second connection element 33 and at least a part of the first connection element 32 are stacked along a thickness direction of the circuit component 31.

The circuit component 31 is configured to provide an electrical wiring for electrically connecting the first connection element 32 and the second connection element 33 to the battery cell 21. The operating status signal of the battery cell 21 can be transmitted to the first connection element 32 and the second connection element 33 through the electrical wiring of the circuit component 31. It can be understood that the circuit component 31 is provided with a plurality of electrical wirings, and the plurality of electrical wirings are electrically connected to the plurality of battery cells 21 in one-to-one correspondence. In some embodiments, the sampling apparatus 30 further includes a plurality of sampling devices 36, and the plurality of sampling devices 36 are electrically connected to the plurality of battery cells 21 in one-to-one correspondence. The electrical wirings are electrically connected to the battery cells 21 through the sampling devices 36. The sampling devices 36 are used to collect the operating status signals of the battery cells 21. The operating status signals of the battery cells 21 collected by the sampling devices 36 are transmitted to the first connection element 32 and the second connection element 33 through the electrical wirings. The sampling devices 36 may be, but are not limited to, a temperature sensor, a voltage sensor, a current sensor, a pressure sensor, etc.

The first connection element 32 is a signal output terminal of the sampling apparatus 30, and the second connection element 33 is another signal output terminal of the sampling apparatus 30. The first connection element 32 and the second connection element 33 are used to output the operating status signals of the battery cells 21 to the battery management module 40. The first connection element 32 is electrically connected to some of the battery cells 21 of the battery 100 through some of the electrical wirings of the circuit component 31, and the second connection element 33 is electrically connected to some other of the battery cells 21 of the battery 100 through some other of the electrical wirings of the circuit component 31. In some embodiments, the first connection element 32 includes a first connector and a plurality of first pins arranged inside the first connector, and the plurality of first pins are electrically connected to some of the electrical wirings of the circuit component 31 in one-to-one correspondence. The second connection element 33 includes a second connector and a plurality of second pins arranged inside the second connector, and the plurality of second pins are electrically connected to some other of the electrical wirings of the circuit component 31 in one-to-one correspondence. The first connector and the second connector are used for connection with the data interface of the battery management module 40, so that the plurality of first pins and the plurality of second pins are electrically connected to the battery management module 40, thereby outputting the operating status signals of the battery cells 21 to the battery management module 40.

In some embodiments, the circuit component 31 includes a substrate having a laying plane, and the electrical wirings are laid on the laying plane. The thickness direction of the circuit component 31 is a direction perpendicular to the laying plane of the substrate. It should be noted that the thickness directions of different parts of the circuit component 31 may be the same or different, depending on the placement state of the circuit component 31. For example, when the circuit component 31 is placed in a flattened state, the thickness directions of different parts of the circuit component 31 are the same; and when the circuit component 31 is placed in a bent state, the thickness directions of two or more non-parallel parts of the circuit component 31 are different.

Taking any plane perpendicular to the thickness direction of the circuit component 31 when the circuit component 31 is in a flattened state as the first reference plane, the expression that at least a part of the second connection element 33 and at least a part of the first connection element 32 are stacked along the thickness direction of the circuit component 31 means that at least a part of the projection of the second connection element 33 on said first reference plane overlaps with at least a part of the projection of the first connection element 32 on said first reference plane. In some embodiments, in the width direction of the circuit component 31, the midline of the projection of the second connection element 33 on said first reference plane coincides with the midline of the projection of the first connection element 32 on said first reference plane, and in the length direction of the circuit component 31, the midline of the projection of the second connection element 33 on said first reference plane coincides with the midline of the projection of the first connection element 32 on said first reference plane. It should be noted that the width direction of the circuit component 31 and the length direction of the circuit component 31 refer to the width direction and the length direction of the circuit component 31 when it is in a flattened state. In some other embodiments, the projection of the second connection element 33 on said first reference plane is entirely located within the coverage range of the projection of the first connection element 32 on said first reference plane, or the projection of the first connection element 32 on said first reference plane is entirely located within the coverage range of the projection of the second connection element 33 on said first reference plane, that is, the second connection element 33 and the first connection element 32 are completely stacked.

At least a part of the second connection element 33 and at least a part of the first connection element 32 are stacked along a thickness direction of the circuit component 31 in the sampling apparatus 30 provided in the embodiments of the present application, which effectively reduces the width dimension of the sampling apparatus 30 compared with the layout structure of a traditional sampling apparatus 30 in which a plurality of connection elements are arranged in sequence along the width direction of the circuit component 31, making the structure of the sampling apparatus 30 more compact, thereby effectively improving the space utilization rate of the battery 100 using the aforementioned sampling apparatus 30 and effectively improving the volume energy density of the battery 100.

In addition, in the related art, since the plurality of connection elements of the sampling apparatus 30 are arranged in sequence along the width direction of the circuit component 31, the width of the part of the substrate used to arranged the connection elements is much larger than the width of the main body part of the substrate. Also, the substrate of the circuit component 31 is usually cut out from the base material. Specifically, a plurality of cutting areas arranged in an array structure are usually divided from the substrate, and the shape of the cutting areas corresponds to the shape of the substrate, and the maximum width of the cutting areas corresponds to the maximum width of the substrate. Since the width of the part of the substrate used to arrange the connection elements is much larger than the width of the main body part of the substrate, and accordingly, the width of the areas of the cutting areas corresponding to the connection elements is also much larger than the width of the main body areas of the cutting areas, the distance between the main body areas of two adjacent cutting areas is large. After the base material is cut, the part of the base material located between the main body areas of the two adjacent cutting areas will be wasted, thereby causing substantial material waste of the base material, which is adverse to reducing the manufacturing cost of the sampling apparatus 30.

At least a part of the second connection element 33 and at least a part of the first connection element 32 are stacked along the thickness direction of the circuit component 31 in the sampling apparatus 30 provided in the embodiments of the present application. Compared with the layout structure of a traditional sampling apparatus 30 in which a plurality of connection elements are arranged in sequence along the width direction of the circuit component 31, the width of the part of the substrate used to arrange the first connection element 32 and the second connection element 33 is effectively reduced, that is, the maximum width of the substrate is reduced. Accordingly, the maximum width of the cutting areas of the base material will also be reduced, thereby effectively reducing the distance between the main body areas of two adjacent cutting areas of the base material, that is, reducing the width of the part of the base material located between the main body areas of the two adjacent cutting areas, thereby effectively reducing the amount of material waste of the base material and effectively reducing the manufacturing cost of the sampling apparatus 30.

In some embodiments of the present application, referring to FIGS. 2, 6 and 11 together, when the sampling apparatus 30 is assembled into the battery 100, the circuit component 31 extends along the stacking direction of the plurality of battery cells 21 of the battery core group 20, that is, the length direction of the circuit component 31 is roughly parallel to the length direction of the battery 100, and the thickness direction of the circuit component 31 is perpendicular to the arrangement direction of the plurality of battery core groups 20, that is, the thickness direction of the circuit component 31 is perpendicular to the width direction of the battery 100, and the width direction of the circuit component 31 is roughly parallel to the width direction of the battery 100.

In the related art, since the plurality of connection elements of the sampling apparatus 30 are arranged in sequence along the width direction of the circuit component 31, the width space of the battery 100 occupied by the circuit component 31 is much larger than the length space of the battery 100 occupied by the circuit component 31, which is adverse to optimizing the internal space layout of the battery 100.

By adopting the above technical solution, not only is the width space of the battery 100 occupied by the sampling apparatus 30 effectively reduced, but also the sampling apparatus 30 can make full use of the length space of the battery 100, thereby effectively improving the space utilization rate of the battery 100 and further improving the volume energy density of the battery 100 using the aforementioned sampling apparatus 30.

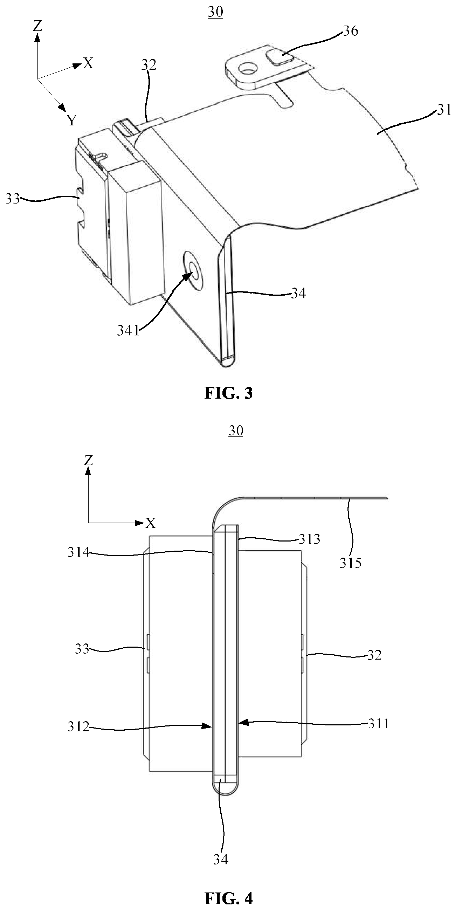

In some embodiments of the present application, referring to FIGS. 4, 8 and 13 together, the circuit component 31 has a first connecting surface 311 and a second connecting surface 312, which are arranged back to back along the thickness direction of the circuit component 31. The first connection element 32 is arranged on the first connecting surface 311 and the second connection element 33 is arranged on the second connecting surface 312.

The first connecting surface 311 is used to provide an assembly environment for the first connection element 32. The first connecting surface 311 may be a flat surface or an arc surface, depending on the shape of the first connection element 32. Similarly, the second connecting surface 312 is used to provide an assembly environment for the second connection element 33. The second connecting surface 312 may be a flat surface or an arc surface, depending on the shape of the second connection element 33.

The expression that first connecting surface 311 and the second connecting surface 312 are arranged back to back along the thickness direction of the circuit component 31 means that the first connecting surface 311 and the second connecting surface 312 are arranged respectively on two sides of the circuit component 31 along the thickness direction. The first connecting surface 311 may be parallel to the second connecting surface 312, that is, the orientation of the first connecting surface 311 is opposite to the orientation of the second connecting surface 312. The first connecting surface 311 may alternatively be arranged at an angle to the second connecting surface 312, that is, the orientation of the first connecting surface 311 is inclined relative to the orientation of the second connecting surface 312.

By adopting the above technical solution, the first connection element 32 and the second connection element 33 can be conveniently connected to the circuit component 31, so that at least a part of the second connection element 33 and at least a part of the first connection element 32 are stacked along the thickness direction of the circuit component 31.

In some embodiments of the present application, and referring to FIGS. 3 and 4 together, the circuit component 31 includes a first connecting portion 313, a second connecting portion 314 and a main body portion 315 connected in sequence, the first connecting portion 313 has a first connecting surface 311, the second connecting portion 314 has a second connecting surface 312, and the first connecting portion 313 is folded relative to the second connecting portion 314 so that the first connecting surface 311 and the second connecting surface 312 are arranged back to back along the thickness direction of the circuit component 31.

The first connecting portion 313 is used to provide an assembly environment for the first connection element 32, and the second connecting portion 314 is used to provide an assembly environment for the second connection element 33. The main body portion 315 is the main body part of the circuit component 31, and the main body portion 315 is connected to the side of the second connecting portion 314 facing away from the first connecting portion 313. It can be understood that the circuit of the first connecting portion 313, the circuit of the second connecting portion 314 and the circuit of the main body portion 315 are in conduction, the first connecting portion 313 is electrically connected to the first connection element 32, the second connecting portion 314 is electrically connected to the second connection element 33, and the main body portion 315 is electrically connected to a plurality of battery cells 21.

Taking any plane parallel to the second connecting surface 312 as a second reference plane, the expression that the first connecting portion 313 is folded relative to the second connecting portion 314 means that after the first connecting portion 313 is bent relative to the second connecting portion 314, at least a part of the projection of the first connecting portion 313 on said second reference plane coincides with at least a part of the projection of the second connecting portion 314 on said second reference plane.

In some embodiments, the first connecting portion 313 and the second connecting portion 314 are parallel to each other, and accordingly, the first connecting surface 311 and the second connecting surface 312 are parallel to each other.

In some embodiments, when the sampling apparatus 30 is assembled into the battery 100, the main body portion 315 is arranged on the top surface of the battery core group 20, and the second connecting portion 314 may be bent relative to the main body portion 315 so that the first connecting portion 313 and the second connecting portion 314 are arranged on the end surface of the battery core group 20, and accordingly, the first connection element 32 and the second connection element 33 are also arranged on the end surface of the battery core group 20. It should be noted that the top surface of the battery core group 20 refers to the surface of the battery core group 20 facing away from the bottom of the box 10 of the battery 100 along the height direction of the battery 100, and the end surface of the battery core group 20 refers to the surface of the battery core group 20 along the length direction of the battery 100.

Of course, in other embodiments, when the sampling apparatus 30 is assembled into the battery 100, the first connecting portion 313 and the second connecting portion 314 may alternatively be arranged on the top surface of the battery core group 20.

By adopting the above technical solution, at least a part of the second connection element 33 and at least a part of the first connection element 32 can be conveniently stacked along the thickness direction of the circuit component 31.

In some embodiments of the present application, the circuit component 31 is a flexible printed circuit.

A Flexible Printed Circuit (FPC) is a printed circuit with good flexibility. The base material of the flexible printed circuit may be, but is not limited to, polyimide, polyester film, etc.

By adopting the above technical solution, not only can the first connecting portion 313 be conveniently folded relative to the second connecting portion 314, but also can the circuit component 31 better adapt to the assembly environment, thereby effectively improving the assembly flexibility of the sampling apparatus 30.

In some embodiments of the present application, referring to FIGS. 3 and 4 together, the sampling apparatus 30 further includes a first reinforcement component 34, which is attached between the first connecting portion 313 and the second connecting portion 314 and is located between the first connecting surface 311 and the second connecting surface 312.

The first reinforcement component 34 is a component for providing a supporting force for connecting the first connection element 32 and the second connection element 33 to the circuit component 31. The first reinforcement component 34 may be, but is not limited to, a reinforcement plate, a reinforcement sheet, etc. It can be understood that the first reinforcement component 34 is made of a rigid material, and the rigid material may be, but is not limited to, aluminum, aluminum alloy, copper, stainless steel, hard plastic, etc. The shape of the first reinforcement component 34 may be, but is not limited to, a square, circle, trapezoid, triangle, etc. The number of the first reinforcement components 34 may be one or two. In some embodiments, the number of the first reinforcement components 34 is two, one first reinforcement component 34 is attached to the surface of the first connecting portion 313 facing away from the first connecting surface 311, and the other first reinforcement component 34 is attached to the surface of the second connecting portion 314 facing away from the second connecting surface 312. In this way, in the process of connecting the first connection element 32 and the second connection element 33 to the circuit component 31, the first connecting portion 313 and the second connecting portion 314 can be unfolded first, and then, with the support from the first reinforcement component 34, the first connection element 32 is connected to the first connecting portion 313 and the second connection element 33 is connected to the second connecting portion 314, and then the first connecting portion 313 is folded relative to the second connecting portion 314 so that the two first reinforcement components 34 are stacked.

In the related art, the first connection element 32 and the second connection element 33 are usually welded to the circuit component 31. Since the circuit component 31 is a flexible printed circuit with poor rigidity, it is unable to effectively provide the supporting force for welding the first connection element 32 and the second connection element 33 to the circuit component 31, resulting in the phenomenon of faulty welding between the first connection element 32 and the circuit component 31 and/or between the second connection element 33 and the circuit component 31.

By adopting the above technical solution, in the process of connecting the first connection element 32 and the second connection element 33 to the circuit component 31, the first reinforcement component 34 can serve to support the first connecting portion 313 and the second connecting portion 314, which facilitates the connection of the first connection element 32 and the second connection element 33 to the first connecting portion 313 and the second connecting portion 314 respectively, thereby effectively reducing the risk of poor connection between the first connection element 32 and the circuit component 31 and between the second connection element 33 and the circuit component 31.

In some embodiments of the present application, the first connecting portion 313 and the second connecting portion 314 are connected to the first reinforcement component 34.

The first connecting portion 313 and the first reinforcement component 34 may be connected by means of, without limitation, adhesion, welding, fastening, etc. In some embodiments, the surface of the first connecting portion 313 facing away from the first connecting surface 311 is fitted against and adhered to the surface of the first reinforcement component 34 facing away from the second connecting portion 314.

The second connecting portion 314 and the first reinforcement component 34 may be connected by means of, without limitation, adhesion, welding, fastening, etc. In some embodiments, the surface of the second connecting portion 314 facing away from the second connecting surface 312 is fitted against and adhered to the surface of the second reinforcement component 35 facing away from the first connecting portion 313.

By adopting the above technical solution, the positions of the first connecting portion 313, the second connecting portion 314 and the first reinforcement component 34 relative to one another are effectively restricted, thereby effectively reducing the risk of the first reinforcement component 34 being separated from the first connecting portion 313 and/or the second connecting portion 314.

In some embodiments of the present application, referring to FIG. 5, the circuit component 31 has a first electrical wiring 3151 electrically connected to the first connection element 32 and a second electrical wiring 3152 electrically connected to the second connection element 33, the first electrical wiring 3151 includes a first main body section 31511 and a first corner section 31512 arranged at an angle to the first main body section 31511, the first main body section 31511 is arranged on the side of the second electrical wiring 3152 facing away from the second connection element 33 and extends from the main body portion 315 to the first connecting portion 313, and the first corner section 31512 is connected between the first connection element 32 and the end of the first main body section 31511 close to the first connection element 32.

The first electrical wiring 3151 is used to electrically connect the first connection element 32 and the battery cell 21, where the first corner section 31512 is used to electrically connect the first pins of the first connection element 32, and the first main body section 31511 is used to directly or indirectly electrically connect a plurality of battery cells 21. In some embodiments, the first electrical wiring 3151 further includes a first branch section (not shown), there are a plurality of first electrical wirings 3151, one end of the plurality of first corner sections 31512 is electrically connected to the plurality of first pins of the first connection element 32 in one-to-one correspondence, the other end of the plurality of first corner sections 31512 is electrically connected to one end of the plurality of first main body sections 31511 in one-to-one correspondence, the other end of the plurality of first main body sections 31511 is electrically connected to one end of the plurality of first branch sections in one-to-one correspondence, and the other end of the plurality of first branch sections is electrically connected to the plurality of battery cells 21 in one-to-one correspondence. The angle formed by the first corner section 31512 and the first main body section 31511 may be a right angle, an acute angle, or an obtuse angle, depending on the actual application requirements.

The second electrical wiring 3152 is used to electrically connect the second connection element 33 and the battery cell 21. In some embodiments, there are a plurality of second electrical wirings 3152, and the plurality of second electrical wirings 3152 are electrically connected to the plurality of second pins of the second connection element 33 in one-to-one correspondence. The plurality of second electrical wirings 3152 are also electrically connected to the plurality of battery cells 21 in one-to-one correspondence.

By adopting the above technical solution, the first electrical wiring 3151 can conveniently avoid the second connection element 33 and the second electrical wiring 3152 for electrically connecting the second connection element 33, effectively optimizing the circuit structure of the circuit component 31 and making the structure of the circuit component 31 more compact, thereby effectively reducing the space occupied by the sampling apparatus 30 and further improving the volume energy density of the battery 100 using the aforementioned sampling apparatus 30.

In some embodiments of the present application, referring to FIG. 5, the second electrical wiring 3152 includes a second main body section 31521 and a second corner section 31522 arranged at an angle to the second main body section 31521, the second main body section 31521 extends from the main body portion 315 to the second connecting portion 314, and the second corner section 31522 is connected between the second connection element 33 and the end of the second main body section 31521 close to the second connection element 33.

The second corner section 31522 is electrically connected to the second pins of the second connection element 33, and the second main body section 31521 is directly or indirectly electrically connected to the plurality of battery cells 21. In some embodiments, there are a plurality of second electrical wirings 3152, the second electrical wirings 3152 each further include a second branch section (not shown), one end of the plurality of second corner sections 31522 is electrically connected to the plurality of second pins of the second electric connection element in one-to-one correspondence, the other end of the plurality of second corner sections 31522 is electrically connected to one end of the plurality of second main body sections 31521 in one-to-one correspondence, the other end of the plurality of second main body sections 31521 is electrically connected to one end of the plurality of second branch sections in one-to-one correspondence, and the other end of the plurality of second branch sections is electrically connected to the plurality of battery cells 21 in one-to-one correspondence. The angle formed by the second corner section 31522 and the second main body section 31521 may be a right angle, an acute angle, or an obtuse angle, depending on the actual application requirements.

By adopting the above technical solution, the circuit structure of the circuit component 31 is further optimized, making the structure of the circuit component 31 more compact, thereby further reducing the space occupied by the sampling apparatus 30 and further improving the volume energy density of the battery 100 using the aforementioned sampling apparatus 30.

In some embodiments of the present application, referring to FIGS. 1 and 5 together, when there are a plurality of battery core groups 20, a plurality of first electrical wirings 3151, and a plurality of second electrical wirings 3152, the circuit component 31 is arranged between two adjacent battery core groups 20, and one end of the plurality of first corner sections 31512 is electrically connected to the plurality of first pins of the first connection element 32 in one-to-one correspondence, the other end of the plurality of first corner sections 31512 is electrically connected to one end of the plurality of first main body sections 31511 in one-to-one correspondence, the other end of the plurality of first main body sections 31511 is electrically connected to one end of the plurality of first branch sections in one-to-one correspondence, the other end of the plurality of first branch sections protrudes from the corresponding first main body section 31511 in the direction away from the second electrical wiring 3152 and is electrically connected to the plurality of battery cells 21 of one battery core group 20 in one-to-one correspondence, one end of the plurality of second corner sections 31522 is electrically connected to the plurality of second pins of the second connection element 33 in one-to-one correspondence, the other end of the plurality of second corner sections 31522 is electrically connected to one end of the plurality of second main body sections 31521 in one-to-one correspondence, the other end of the plurality of second main body sections 31521 is electrically connected to one end of the plurality of second branch sections in one-to-one correspondence, and the other end of the plurality of second branch sections protrudes from the corresponding second main body section 31521 in the direction away from the first electrical wiring 3151 and is electrically connected to the plurality of battery cells 21 of another battery core group 20 in one-to-one correspondence.

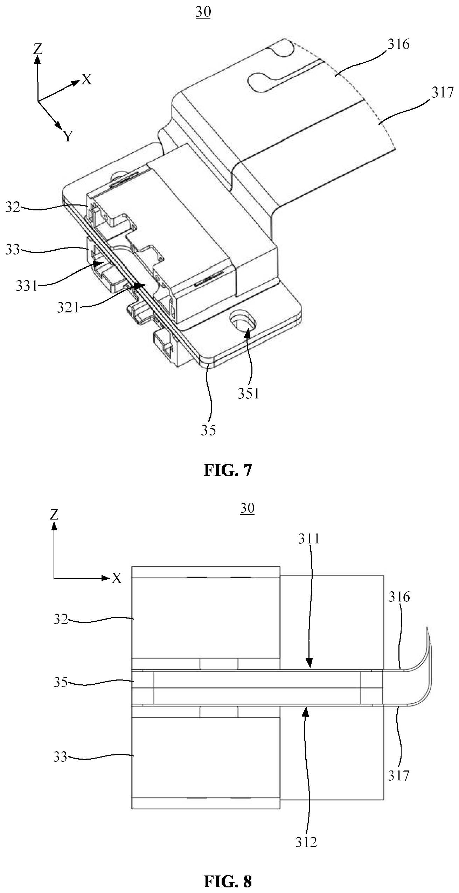

In some embodiments of the present application, referring to FIGS. 7 and 8 together, the circuit component 31 includes a first board body 316 and a second board body 317 which are stacked. The first board body 316 has a first connecting surface 311 and the second board body 317 has a second connecting surface 312.

The first board body 316 is used to electrically connect the first connection element 32 and the battery cell 21, and the second board body 317 is used to electrically connect the second connection element 33 and the battery cell 21. The expression that the first board body 316 and the second board body 317 are stacked means that at least a part of the first board body 316 and at least a part of the second board body 317 are arranged opposite to each other in the thickness direction of the circuit component 31. It can be understood that the first connecting surface 311 is arranged on the board surface of the first board body 316 facing away from the second board body 317, and the second connecting surface 312 is arranged on the board surface of the second board body 317 facing away from the first board body 316.

By adopting the above technical solution, at least a part of the second connection element 33 and at least a part of the first connection element 32 can be conveniently stacked along the thickness direction of the circuit component 31.

In some embodiments of the present application, the first board body 316 and the second board body 317 are flexible printed circuits.

In some embodiments, when the sampling apparatus 30 is assembled into the battery 100, the first board body 316 and the second board body 317 extend along the stacking direction of the plurality of battery cells 21 of the battery core group 20, that is, the length direction of the first board body 316 and the length direction of the second board body 317 are roughly parallel to the length direction of the battery 100, and the main body part of the first board body 316 and the main body part of the second board body 317 are arranged on the top surface of the battery core group 20. One end of the first board body 316 and one end of the second board body 317 can be bent in the direction close to the end surface of the battery core group 20 to form a bent portion. The first connection element 32 is connected to the bent portion of the first board body 316, and the second connection element 33 is connected to the bent portion of the second board body 317, so that the first connection element 32 and the second connection element 33 are arranged on the end surface of the battery core group 20.

Of course, in other embodiments, the first board body 316 and the second board body 317 may both be arranged on the top surface of the battery core group 20, so that the first connection element 32 and the second connection element 33 are also arranged on the top surface of the battery core group 20.

By adopting the above technical solution, the circuit component 31 can better adapt to the assembly environment, thereby effectively improving the assembly flexibility of the sampling apparatus 30.

In some embodiments of the present application, referring to FIGS. 7 and 8 together, the sampling apparatus 30 further includes a second reinforcement component 35, which is attached between the first board body 316 and the second board body 317 and is located between the first connecting surface 311 and the second connecting surface 312.

The second reinforcement component 35 is a component for providing a supporting force for connecting the first connection element 32 and the second connection element 33 to the circuit component 31. The second reinforcement component 35 may be, but is not limited to, a reinforcement plate, a reinforcement sheet, etc. It can be understood that the second reinforcement component 35 is made of a rigid material, and the rigid material may be, but is not limited to, aluminum, aluminum alloy, copper, stainless steel, hard plastic, etc. The shape of the second reinforcement component 35 may be, but is not limited to, a square, circle, trapezoid, triangle, etc. The number of the second reinforcement components 35 may be one or two. In some embodiments, the number of the second reinforcement components 35 is two, one second reinforcement component 35 is attached to the board surface of the first board body 316 facing away from the first connecting surface 311, and the other second reinforcement component 35 is attached to the board surface of the second board body 317 facing away from the second connecting surface 312. In this way, in the process of connecting the first connection element 32 and the second connection element 33 to the circuit component 31, the first connection element 32 and the second connection element 33 can be first connected to the first board body 316 and the second board body 317 respectively, and then the first board body 316 and the second board body 317 are stacked to make the two second reinforcement components 35 stacked.

In the related art, the first connection element 32 and the second connection element 33 are usually welded to the circuit component 31. Since the first board body 316 and the second board body 317 are flexible printed circuits with poor rigidity, they are unable to effectively provide the supporting force for welding the first connection element 32 and the second connection element 33 to the circuit component 31, resulting in the phenomenon of faulty welding between the first connection element 32 and the first board body 316 and/or between the second connection element 33 and the second board body 317.

By adopting the above technical solution, in the process of connecting the first connection element 32 and the second connection element 33 to the circuit component 31, the second reinforcement component 35 can serve to support the first board body 316 and the second board body 317, which facilitates the connection of the first connection element 32 and the second connection element 33 to the first board body 316 and the second board body 317 respectively, thereby effectively reducing the risk of poor connection between the first connection element 32 and the first board body 316 and between the second connection element 33 and the second board body 317.

In some embodiments of the present application, the first board body 316 and the second board body 317 are connected to the second reinforcement component 35.

The first board body 316 and the second reinforcement component 35 may be connected by means of, without limitation, adhesion, welding, fastening, etc. In some embodiments, the board surface of the first board body 316 facing away from the first connecting surface 311 is fitted against and adhered to the surface of the second reinforcement component 35 facing away from the second board body 317.

The second board body 317 and the second reinforcement component 35 may be connected by means of, without limitation, adhesion, welding, fastening, etc. In some embodiments, the board surface of the second board body 317 facing away from the second connecting surface 312 is fitted against and adhered to the surface of the second reinforcement component 35 facing away from the first board body 316.

By adopting the above technical solution, the positions of the first board body 316, the second board body 317 and the second reinforcement component 35 relative to one another are effectively restricted, thereby effectively reducing the risk of the second reinforcement component 35 being separated from the first board body 316 and/or the second board body 317.

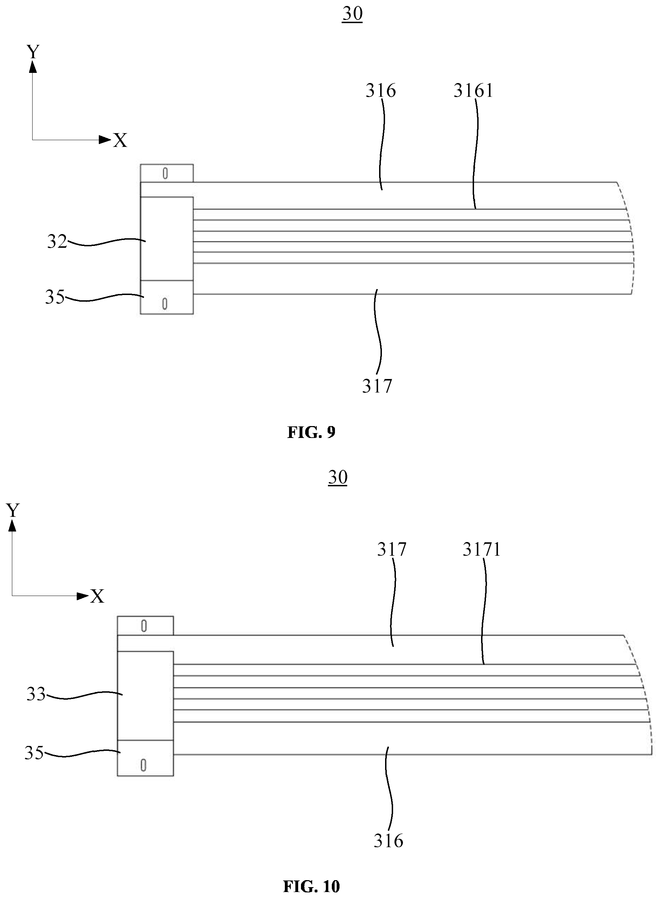

In some embodiments of the present application, referring to FIGS. 9 and 10 together, the first board body 316 has a third electrical wiring 3161 electrically connected to the first connection element 32, and the third electrical wiring 3161 extends along the length direction of the circuit component 31; the second board body 317 has a fourth electrical wiring 3171 electrically connected to the second connection element 33, and the fourth electrical wiring 3171 extends along the length direction of the circuit component 31.

The third electrical wiring 3161 is used to electrically connect the first connection element 32 and the battery cell 21. In some embodiments, the third electrical wiring 3161 includes a third main body section and a third branch section (not shown), and there are a plurality of third electrical wirings 3161, and the plurality of third main body sections extend along the length direction of the circuit component 31, one end of the plurality of third main body sections is electrically connected to the plurality of first pins of the first connection element 32 in one-to-one correspondence, the other end of the plurality of third main body sections is electrically connected to one end of the plurality of third branch sections in one-to-one correspondence, and the other end of the plurality of third branch sections is electrically connected to the plurality of battery cells 21 in one-to-one correspondence.

The fourth electrical wiring 3171 is used to electrically connect the second connection element 33 and the battery cell 21. In some embodiments, the fourth electrical wiring 3171 includes a fourth main body section and a fourth branch section (not shown). There are a plurality of fourth electrical wirings 3171, and the plurality of fourth main body sections extend along the length direction of the circuit component 31. One end of the plurality of fourth main body sections is electrically connected to the plurality of second pins of the second connection element 33 in one-to-one correspondence, the other end of the plurality of fourth main body sections is electrically connected to one end of the plurality of fourth branch sections in one-to-one correspondence, and the other end of the plurality of fourth branch sections is electrically connected to the plurality of battery cells 21 in one-to-one correspondence.

In some embodiments, referring to FIGS. 6, 9 and 10 together, when there are a plurality of battery core groups 20, a plurality of third electrical wirings 3161 and a plurality of fourth electrical wirings 3171, the circuit component 31 is arranged between two adjacent battery core groups 20, a plurality of third main body sections extend along the length direction of the circuit component 31, one end of the third main body sections is electrically connected to a plurality of first pins of the first connection element 32 in one-to-one correspondence, the other end of the plurality of third main body sections is electrically connected to one end of the plurality of third branch sections in one-to-one correspondence, the other end of the plurality of third branch sections protrudes from the corresponding third main body section in the direction close to one battery core group 20 and is electrically connected to the plurality of battery cells 21 of the battery core group 20 in one-to-one correspondence, the plurality of fourth main body sections extend along the length direction of the circuit component 31, one end of the plurality of fourth main body sections is electrically connected to the plurality of second pins of the second connection element 33 in one-to-one correspondence, the other end of the plurality of fourth main body sections is electrically connected to one end of the plurality of fourth branch sections in one-to-one correspondence, and the other end of the plurality of fourth branch sections protrudes from the corresponding fourth main body section in the direction close to the other battery core group 20 and is electrically connected to the plurality of battery cells 21 of the battery core group 20 in one-to-one correspondence.

By adopting the above technical solution, the circuit structure of the circuit component 31 is effectively optimized, making the structure of the circuit component 31 more compact, thereby effectively reducing the space occupied by the sampling apparatus 30 and further improving the volume energy density of the battery 100 using the aforementioned sampling apparatus 30.

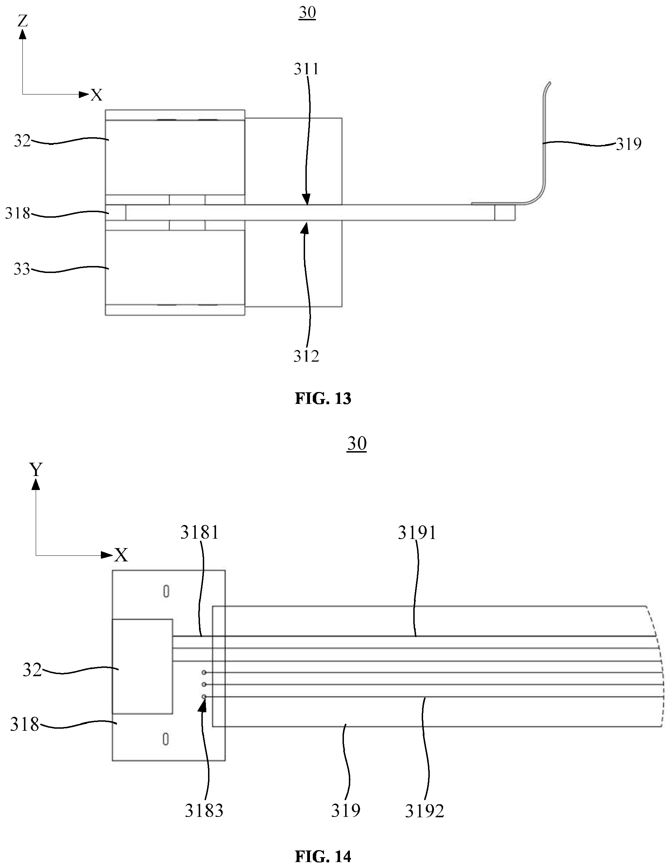

In some embodiments of the present application, referring to FIGS. 12 and 13 together, the circuit component 31 includes a third board body 318. The third board body 318 is a rigid printed circuit and has a first connecting surface 311 and a second connecting surface 312.

The third board body 318 is used to electrically connect the first connection element 32 and the second connection element 33. Specifically, the first connecting surface 311 and the second connecting surface 312 are respectively arranged on two sides of the third board body 318 along the thickness direction. The first connection element 32 is electrically connected to the first connecting surface 311, and the second connection element 33 is electrically connected to the second connecting surface 312. The third board body 318 is a rigid printed circuit, which may be, but is not limited to, phenolic paper laminate, epoxy paper laminate, polyester glass felt laminate, epoxy glass cloth laminate, etc.

By adopting the above technical solution, the third plate body 318 has good rigidity, which facilitates connecting the first connection element 32 and the second connection element 33 to the third board body 318, thereby effectively reducing the risk of poor connection between the first connection element 32 and the third board body 318 and between the second connection element 33 and the third board body 318, and there is no need to provide additional reinforcement components, which effectively simplifies the structure of the sampling apparatus 30, thereby effectively reducing the space occupied by the sampling apparatus 30, and further improving the volume energy density of the battery 100 using the aforementioned sampling apparatus 30.

In some embodiments of the present application, referring to FIGS. 12 and 13 together, the circuit component 31 further includes a fourth board body 319, the fourth board body 319 is a flexible printed circuit, and the fourth board body 319 is electrically connected to the third board body 318.

The fourth board body 319 is used to electrically connect the third board body 318 and the battery cell 21. The fourth board body 319 may be connected to the first connecting surface 311 or the second connecting surface 312.

In some embodiments, when the sampling apparatus 30 is assembled into the battery 100, the fourth board body 319 extends along the stacking direction of the plurality of battery cells 21 of the battery core group 20, that is, the length direction of the fourth board body 319 is roughly parallel to the length direction of the battery 100, the main body part of the fourth board body 319 is arranged on the top surface of the battery core group 20, one end of the fourth board body 319 can be bent in the direction close to the end surface of the battery core group 20 to form a bent portion, and the third board body 318 is connected to the bent portion of the fourth board body 319, so that the first connection element 32 and the second connection element 33 are arranged on the end surface of the battery core group 20.

Of course, in other embodiments, the fourth board body 319 may be completely arranged on the top surface of the battery core group 20, and the third board body 318 is also arranged on the top surface of the battery core group 20, so that the first connection element 32 and the second connection element 33 are also arranged on the top surface of the battery core group 20.

By adopting the above technical solution, the circuit component 31 can better adapt to the assembly environment, thereby effectively improving the assembly flexibility of the sampling apparatus 30.

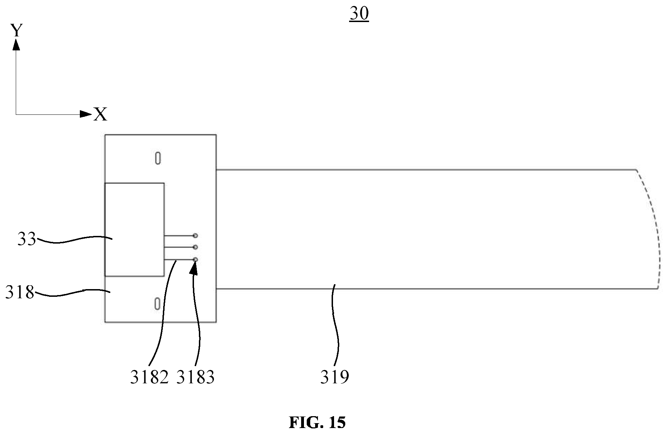

In some embodiments of the present application, referring to FIGS. 14 and 15 together, the third board body 318 has a fifth electrical wiring 3181 arranged on the first connecting surface 311 and a sixth electrical wiring 3182 arranged on the second connecting surface 312, and the circuit component 31 further includes a fourth board body 319, the fourth board body 319 has a seventh electrical wiring 3191 and an eighth electrical wiring 3192, the seventh electrical wiring 3191 is electrically connected to the first connection element 32 through the fifth electrical wiring 3181, and the eighth electrical wiring 3192 is electrically connected to the second connection element 33 through the sixth electrical wiring 3182.

The fifth electrical wiring 3181 is used to electrically connect the first pins of the first connection element 32, the sixth electrical wiring 3182 is used to electrically connect the second pins of the second connection element 33, the seventh electrical wiring 3191 is used to electrically connect the fifth electrical wiring 3181 and the battery cell 21, and the eighth electrical wiring 3192 is used to electrically connect the sixth electrical wiring 3182 and the battery cell 21.

In some embodiments, referring to FIGS. 11, 14 and 15 together, when there are a plurality of battery core groups 20, a plurality of fifth electrical wirings 3181, a plurality of sixth electrical wirings 3182, a plurality of seventh electrical wirings 3191 and a plurality of eighth electrical wirings 3192, the circuit component 31 is arranged between two adjacent battery core groups 20, the plurality of fifth electrical wirings 3181 and the plurality of sixth electrical wirings 3182 extend along the length direction of the circuit component 31, and one end of the plurality of fifth electrical wirings 3181 is electrically connected to the plurality of first pins of the first connection element 32 in one-to-one correspondence. The seventh electrical wiring 3191 includes a fifth main body section and a fifth branch section, the fifth main body section extends along the length direction of the circuit component 31, the other end of the plurality of fifth electrical wirings 3181 is electrically connected to one end of the plurality of fifth main body sections in one-to-one correspondence, the other end of the plurality of fifth main body sections is electrically connected to one end of the plurality of fifth branch sections in one-to-one correspondence, the other end of the plurality of fifth branch sections protrudes from the corresponding fifth main body section in the direction close to the battery core group 20 and is electrically connected to the plurality of battery cells 21 of the battery core group 20 in one-to-one correspondence, and one end of the plurality of sixth electrical wirings 3182 is electrically connected to the plurality of second pins of the second connection element 33 in one-to-one correspondence. The eighth electrical wiring 3192 includes a sixth main body section and a sixth branch section, the sixth main body section extends along the length direction of the circuit component 31, the other end of the plurality of sixth electrical wirings 3182 is electrically connected to one end of the plurality of sixth main body sections in one-to-one correspondence, the other end of the plurality of sixth main body sections is electrically connected to one end of the plurality of sixth branch sections in one-to-one correspondence, the other end of the plurality of sixth branch sections protrudes from the corresponding sixth main body section in the direction close to the other battery core group 20 and is electrically connected to the plurality of battery cells 21 of the battery core group 20 in one-to-one correspondence.

By adopting the above technical solution, the first connection element 32 and the second connection element 33 can be electrically connected to the circuit component 31 conveniently.

In some embodiments of the present application, referring to FIGS. 14 and 15 together, a wire hole 3183 running through the first connecting surface 311 and the second connecting surface 312 is formed in the third board body 318. The fourth board body 319 is connected to the first connecting surface 311, and the eighth electrical wiring 3192 is electrically connected to the sixth electrical wiring 3182 through the wire hole 3183.

The expression that the wire hole 3183 runs through the first connecting surface 311 and the second connecting surface 312 means that one end opening of the wire hole 3183 is formed in the first connecting surface 311, and the other end opening of the wire hole 3183 is formed in the second connecting surface 312.

It can be understood that the fourth board body 319 is connected to the first connecting surface 311, the fifth electrical wiring 3181 and the seventh electrical wiring 3191 can be directly electrically connected on the first connecting surface 311, and the eighth electrical wiring 3192 and the sixth electrical wiring 3182 are electrically connected through the wire hole 3183. For example, the eighth electrical wiring 3192 and the sixth electrical wiring 3182 can be electrically connected in the wire hole 3183 by welding.

In some other embodiments of the present application, the fourth board body 319 is connected to the second connecting surface 312, and the seventh electrical wiring 3191 is electrically connected to the fifth electrical wiring 3181 through the wire hole 3183.

It can be understood that the fourth board body 319 is connected to the second connecting surface 312, the eighth electrical wiring 3192 and the sixth electrical wiring 3182 can be directly electrically connected on the second connecting surface 312, and the seventh electrical wiring 3191 and the fifth electrical wiring 3181 are electrically connected through the wire hole 3183. For example, the seventh electrical wiring 3191 and the fifth electrical wiring 3181 can be electrically connected in the wire hole 3183 by welding.

By adopting the above technical solution, the circuit structure of the circuit component 31 is effectively optimized, making the structure of the circuit component 31 more compact, thereby effectively reducing the space occupied by the sampling apparatus 30 and further improving the volume energy density of the battery 100 using the aforementioned sampling apparatus 30.

In some embodiments of the present application, referring to FIGS. 7 and 12 together, the first connection element 32 has a first plug port 321, the second connection element 33 has a second plug port 331, and the orientation of the first plug port 321 is the same as the orientation of the second plug port 331.

It can be understood that when the first connection element 32 includes a first connector and a first pin, the first plug port 321 is formed on the first connector, and the first pin is in communication with the external environment of the first connection element 32 through the first plug port 321. When the second connection element 33 includes a second connector and a second pin, the second plug port 331 is formed on the second connector, and the second pin is in communication with the external environment of the second connection element 33 through the second plug port 331. The orientation of the first plug port 321 refers to the plugging and unplugging direction of the first connection element 32, for example, the direction in which the first connection element 32 is plugged into the battery management module 40 or the direction in which the first connection element 32 is unplugged from the battery management module 40. Similarly, the orientation of the second plug port 331 refers to the plugging and unplugging direction of the second connection element 33, for example, the direction in which the second connection element 33 is plugged into the battery management module 40 or the direction in which the second connection element 33 is unplugged from the battery management module 40.

By adopting the above technical solution, the first connection element 32 and the second connection element 33 can be plugged and unplugged along the same direction, thereby effectively improving the efficiency of connecting the sampling apparatus 30 with the external apparatus.

In some embodiments of the present application, the orientation of the first plug port 321 is parallel to the width direction of the circuit component 31. In other words, when the width direction of the circuit component 31 is parallel to the width direction of the battery 100, the plugging and unplugging directions of the first connection element 32 and the second connection element 33 are the width direction of the battery 100.

In some other embodiments of the present application, referring to FIGS. 7 and 12 together, the orientation of the first plug port 321 is parallel to the length direction of the circuit component 31. In other words, when the length direction of the circuit component 31 is parallel to the length direction of the battery 100, the plugging and unplugging directions of the first connection element 32 and the second connection element 33 are the length direction of the battery 100.

By adopting the above technical solution, the risk of the first connection element 32 and the second connection element 33 interfering with other components of the battery 100 during the plugging and unplugging process is effectively reduced. For example, the risk of the first connection element 32 and the second connection element 33 interfering with the box 10 of the battery 100 during the plugging and unplugging process is effectively reduced.

In a second aspect, referring to FIGS. 2, 6 and 11 together, an embodiment of the present application provides a battery 100, including the sampling apparatus 30 according to any of the above embodiments.

In some embodiments, the battery 100 further includes a battery management module 40 and a battery core group 20, and the sampling apparatus 30 is used to electrically connect the battery management module 40 and the plurality of battery cells 21 in the battery core group 20.

As the battery 100 provided by the embodiment of the present application uses the sampling apparatus 30 of any of the above embodiments, the space utilization rate of the battery 100 is effectively improved, thereby effectively improving the volume energy density of the battery 100.

In some embodiments of the present application, referring to FIGS. 2, 6 and 11 together, the battery 100 further includes a mounting seat 50, and the first connection element 32 and the second connection element 33 are mounted on the mounting seat 50.

The mounting seat 50 is used to provide a mounting environment for the first connection element 32 and the second connection element 33. The mounting seat 50 may be arranged between the battery management module 40 and the battery core group 20. The mounting seat 50 may be made of, without limitation, aluminum, aluminum alloy, copper, stainless steel, hard plastic, etc. In some embodiments, in order to improve the insulation performance of the battery 100, the mounting seat 50 may be made of an insulating material, for example, the mounting seat 50 is made of hard plastic.

In some embodiments, referring to FIGS. 2 and 3 together, the circuit component 31 includes a first connecting portion 313 and a second connecting portion 314. The first connection element 32 is connected to the first connecting portion 313, and the second connection element 33 is connected to the second connecting portion 314. The sampling apparatus 30 includes a first reinforcement component 34. The first connecting portion 313 and the second connecting portion 314 are connected to the first reinforcement component 34. A first connecting hole 341 is formed in the first reinforcement component 34. The first reinforcement component 34 is connected to the mounting seat 50 by passing a fastener through the first connecting hole 341. The fastener may be, but is not limited to, bolts, screws, rivets, etc.

In some other embodiments, referring to FIGS. 6 and 7 together, the circuit component 31 includes a first board body 316 and a second board body 317. The first connection element 32 is connected to the first board body 316, and the second connection element 33 is connected to the second board body 317. The sampling apparatus 30 includes a second reinforcement component 35. The first board body 316 and the second board body 317 are connected to the second reinforcement component 35. A second connecting hole 351 is formed in the second reinforcement component 35. The second reinforcement component 35 is connected to the mounting seat 50 by passing a fastener through the second connecting hole 351. The fastener may be, but is not limited to, bolts, screws, rivets, etc.

In yet some other embodiments, referring to FIGS. 11 and 12 together, the circuit component 31 includes a third board body 318, and the third board body 318 is a rigid printed circuit. The first connection element 32 and the second connection element 33 are connected to the third board body 318. A third connecting hole 3184 is formed in the third board body 318. The third board body 318 is connected to the mounting seat 50 by passing a fastener through the third connecting hole 3184. The fastener may be, but is not limited to, bolts, screws, rivets, etc.

By adopting the above technical solution, the first connection element 32 and the second connection element 33 can be conveniently fixed.

In some embodiments of the present application, referring to FIGS. 2, 6 and 11 together, a receiving groove 51 is formed in the mounting seat 50, and the first connection element 32 and/or the second connection element 33 is received in the receiving groove 51.

The receiving groove 51 is used to provide an accommodating space for the first connection element 32 and/or the second connection element 33. In some embodiments, the first connection element 32 is received in the receiving groove 51. In some other embodiments, the second connection element 33 is received in the receiving groove 51. In yet some other embodiments, the first connection element 32 and the second connection element 33 are received in the receiving groove 51.

By adopting the above technical solution, the assembly structure between the first connection element 32 and/or the second connection element 33 and the mounting seat 50 becomes more compact, thereby further improving the space utilization rate of the battery 100 and further improving the volume energy density of the battery 100.

In a third aspect, referring to FIG. 1, an embodiment of the present application provides an electrical device, including the battery 100 of any of the above embodiments.

As the electrical device provided in the embodiment of the present application uses the battery 100 described in any of the above embodiments, the battery life performance of the electrical device is effectively improved.

The foregoing description illustrates merely preferred embodiments of the present application, but is not intended to limit present application. Any modification, equivalent substitution, or improvement made within the spirit and principle of present application shall fall within the protection scope of the present application.

## Claims

1. A sampling apparatus, comprising:
a circuit component;
a first connection element electrically connected to the circuit component; and
a second connection element electrically connected to the circuit component, at least a part of the second connection element and at least a part of the first connection element being stacked along a thickness direction of the circuit component.

2. The sampling apparatus of claim 1, wherein the circuit component has a first connecting surface and a second connecting surface which are arranged back to back along the thickness direction of the circuit component, the first connection element is arranged on the first connecting surface, and the second connection element is arranged on the second connecting surface.

3. The sampling apparatus of claim 2, wherein the circuit component comprises a first connecting portion, a second connecting portion and a main body portion connected in sequence, the first connecting portion has the first connecting surface, the second connecting portion has the second connecting surface, and the first connecting portion is folded relative to the second connecting portion, so that the first connecting surface and the second connecting surface are arranged back to back along the thickness direction of the circuit component.

4. The sampling apparatus of claim 3, wherein the circuit component is a flexible printed circuit.

5. The sampling apparatus of claim 4, wherein the sampling apparatus further comprises a first reinforcement component, which is attached between the first connecting portion and the second connecting portion and is located between the first connecting surface and the second connecting surface.

6. The sampling apparatus of claim 5, wherein the first connecting portion and the second connecting portion are connected to the first reinforcement component.

7. The sampling apparatus of any one of claims 3 to 6, wherein the circuit component has a first electrical wiring electrically connected to the first connection element and a second electrical wiring electrically connected to the second connection element, the first electrical wiring comprises a first main body section and a first corner section arranged at an angle to the first main body section, the first main body section is arranged on the side of the second electrical wiring facing away from the second connection element and extends from the main body portion to the first connecting portion, and the first corner section is connected between the first connection element and the end of the first main body section close to the first connection element.

8. The sampling apparatus of claim 7, wherein the second electrical wiring comprises a second main body section and a second corner section arranged at an angle to the second main body section, the second main body section extends from the main body portion to the second connecting portion, and the second corner section is connected between the second connection element and the end of the second main body section close to the second connection element.

9. The sampling apparatus of claim 2, wherein the circuit component comprises a first board body and a second board body which are stacked, the first board body has the first connecting surface, and the second board body has the second connecting surface.

10. The sampling apparatus of claim 9, wherein the first board body and the second board body are flexible printed circuits.

11. The sampling apparatus of claim 10, wherein the sampling apparatus further comprises a second reinforcement component which is attached between the first board body and the second board body and is located between the first connecting surface and the second connecting surface.

12. The sampling apparatus of claim 11, wherein the first board body and the second board body are connected to the second reinforcement component.

13. The sampling apparatus of any one of claims 9 to 12, wherein the first board body has a third electrical wiring electrically connected to the first connection element, and the third electrical wiring extends along a length direction of the circuit component; the second board body has a fourth electrical wiring electrically connected to the second connection element, and the fourth electrical wiring extends along the length direction of the circuit component.

14. The sampling apparatus of claim 2, wherein the circuit component comprises a third board body, the third board body is a rigid printed circuit, and the third board body has the first connecting surface and the second connecting surface.

15. The sampling apparatus of claim 14, wherein the circuit component further comprises a fourth board body, the fourth board body is a flexible printed circuit, and the fourth board body is electrically connected to the third board body.

16. The sampling apparatus of claim 14, wherein the third board body has a fifth electrical wiring arranged on the first connecting surface and a sixth electrical wiring arranged on the second connecting surface, and the circuit component further comprises a fourth board body, the fourth board body has a seventh electrical wiring and an eighth electrical wiring, the seventh electrical wiring is electrically connected to the first connection element through the fifth electrical wiring, and the eighth electrical wiring is electrically connected to the second connection element through the sixth electrical wiring.

17. The sampling apparatus of claim 16, wherein
a wire hole running through the first connecting surface and the second connecting surface is formed in the third board body;
the fourth board body is connected to the first connecting surface, and the eighth electrical wiring is electrically connected to the sixth electrical wiring through the wire hole; or,
the fourth board body is connected to the second connecting surface, and the seventh electrical wiring is electrically connected to the fifth electrical wiring through the wire hole.

18. The sampling apparatus of any one of claims 1 to 17, wherein the first connection element has a first plug port, the second connection element has a second plug port, and the orientation of the first plug port is the same as the orientation of the second plug port.

19. The sampling apparatus of claim 18, wherein
the orientation of the first plug port is parallel to the width direction of the circuit component; or,
the orientation of the first plug port is parallel to the length direction of the circuit component.

20. A battery, comprising a sampling apparatus of any one of claims 1 to 19.

21. The battery of claim 20, wherein the battery further comprises a plurality of battery cells, and the plurality of battery cells are electrically connected to the circuit component.

22. The battery of claim 21, wherein the plurality of battery cells are stacked in sequence to form a battery core group, and the circuit component extends along the stacking direction of the plurality of battery cells.

23. The battery of claim 22, wherein there are a plurality of battery core groups, and the plurality of battery core groups are arranged in sequence along a direction perpendicular to the stacking direction of the plurality of battery cells, and the thickness direction of the circuit component is perpendicular to the arrangement direction of the plurality of battery core groups.

24. The battery of any one of claims 20 to 23, wherein the battery further comprises a mounting seat, and the first connection element and the second connection element are mounted on the mounting seat.

25. The battery of claim 24, wherein a receiving groove is formed in the mounting seat, and the first connection element and/or the second connection element is received in the receiving groove.

26. An electrical device, comprising a battery of any one of claims 20 to 25.
